# EUROPÄISCHE PATENTSCHRIFT

(11) **EP 4 058 400 B1**
(45) Veröffentlichungstag und Bekanntmachung des Hinweises auf die Patenterteilung: **10.09.2025**
(21) Anmeldenummer: 19812695.5
(22) Anmeldetag: 13.11.2019
(51) Int. Cl.: B81B 3/00

(54) **MEMS-BAUTEIL MIT IN DER EBENE BEWEGLICHEM ELEMENT**
MEMS COMPONENT WITH IN-PLANE MOVABLE ELEMENT
COMPOSANT MEMS COMPRENANT UN ÉLÉMENT MOBILE DANS LE PLAN

(43) Veröffentlichungstag der Anmeldung: 21.09.2022
(73) Patentinhaber: Fraunhofer-Gesellschaft zur Förderung der angewandten Forschung e.V., 80686 München (DE)
(72) Erfinder: KAISER, Bert, 01109 Dresden (DE)
(74) Vertreter: 2SPL Patentanwälte PartG mbB
(86) Internationale Anmeldenummer: PCT/EP2019/081217
(87) Internationale Veröffentlichungsnummer: WO 2021/093950

(56) Entgegenhaltungen:
- DE-A1- 102010 029 936
- DE-A1- 102017 203 722
- US-A1- 2017 363 493

## Beschreibung

### Technisches Gebiet

Die vorliegende Offenbarung befasst sich mit mikromechanischen (engl. MicroElectroMechanical Systems, MEMS) Bauelementen. Insbesondere betreffen Ausführungsbeispiele ein MEMS-Bauteil, eine Baugruppe mit dem MEMS-Bauteil sowie Verfahren zum Betreiben des MEMS-Bauteils.

### Hintergrund

MEMS-Bauelemente können auf vielfache Weise genutzt werden, um mit einem Gas oder einer Flüssigkeit in der Umgebung zu interagieren. Beispielsweise können MEMS-Bauelemente genutzt werden, um ein Gas in der Umgebung zu Schwingungen anzuregen. Derartige MEMS-Bauelemente können beispielsweise für Lautsprecher verwendet werden. Auch können MEMS-Bauelemente genutzt werden, um Schwingungen eines Gases in der Umgebung zu detektieren. Derartige MEMS-Bauelemente können beispielsweise für Mikrofone verwendet werden.

Ferner werden in der Literatur eine Vielzahl von passiven Elementen, die mit auslenkbaren Aktuatoren verbunden werden können, vorgeschlagen. Beispielhaft sei auf hier die Vielzahl an Mikrospiegelanwendungen verwiesen. Gleichermaßen können Membranen für Lautsprecher oder Mikrofonen auch als passive Elemente gewertet werden. Allen Technologien ist dabei aber gleich, dass die Auslenkung der passiven Elemente aus der Substratebene heraus erfolgt (engl. out-of-plane).

Eine Bewegung in der Ebene (engl. in-plane) eines passiven Elements, das durch mikromechanische Aktuatoren angetrieben ist, wird in Dokument DE 10 2017 206 766 A1 vorgeschlagen. Dabei sind auslenkbare Elemente gegenüberliegend einseitig mit einem umgebenden Substrat verbunden. Die jeweiligen frei beweglichen Enden sind mit Platten über Federelemente oder starre Elemente verbunden und können so Kräfte auf die Platte übertragen. Mindestens zwei solcher Platten sind gegenüberliegend angeordnet und schließen seitlich eine Kavität ab, die mit der Umgebung durch eine Öffnung im Substrat verbunden ist. Um den veränderlichen geometrischen Abmessungen der Aktuatoren bei der Auslenkung Rechnung zu tragen, müssen die Platten über Federelemente mit den Aktuatoren verbunden sein. Dies wirkt sich nachteilig auf die Leistungsfähigkeit der resultierenden Wandler aus, da die Federn die Schwingungseigenschaften des Gesamtsystems beeinflusst.

Wünschenswert wäre ein MEMS-Element, mit dem ein hoher Schalldruck bei minimierter Bauteiloberfläche erreichbar ist. Das MEMS-Element sollte bei optimierter Platzausnutzung eine große fluidische Wirkfläche in der Substratebene zur Interaktion mit einem umgebenden Fluid (Umgebungsfluid) bereitstellen und dabei gleichzeitig einen minimierten Kapazitätsbelag der Bauteiloberfläche aufweisen.

Vor diesem Hintergrund ist es eine Aufgabe, eine verbesserte MEMS-Struktur zur Interaktion mit einem Umgebungsfluid bereitzustellen.

### Zusammenfassung

Die Aufgabe wird erfindungsgemäß durch ein MEMS-Bauteil gemäß dem unabhängigen Anspruch gelöst. Weitere Aspekte sowie Weiterbildungen der Erfindung sind in den abhängigen Ansprüchen, der folgenden Beschreibung sowie in den Figuren beschrieben.

Die Erfindung betrifft daher ein MEMS-Bauteil umfassend einen Schichtstapel mit zumindest einer zwischen einer ersten Schicht und einer dritten Schicht gebildeten zweiten Schicht. In der zweiten Schicht ist zumindest eine erste Kavität gebildet. Das MEMS-Bauteil umfasst ferner ein lateral auslenkbares Element, das ein mit einer Seitenwand der ersten Kavität verbundenes Ende sowie ein freies Ende aufweist. Das lateral auslenkbare Element ist in der Ebene der zweiten Schicht auslenkbar. Weiterhin umfasst das MEMS-Bauteil ein passives Element, das starr an das freie Ende des lateral auslenkbaren Elements angebunden ist, um einer Bewegung des lateral auslenkbaren Elements zu folgen. Das lateral auslenkbare Element und das passive Element unterteilen die erste Kavität in eine erste Teilkavität und eine zweite Teilkavität. Die erste Teilkavität steht über zumindest eine erste Öffnung mit einem Umgebungsfluid des MEMS-Bauteils in Kontakt. Ferner steht die zweite Teilkavität über zumindest eine zweite Öffnung mit dem Umgebungsfluid des MEMS-Bauteils in Kontakt. Die zumindest eine zweite Öffnung ist in der ersten Schicht oder der dritten Schicht gebildet. Die zumindest eine erste Öffnung ist in einer anderen Schicht der ersten Schicht und der dritten Schicht als die zumindest eine zweite Öffnung gebildet.

Das passive Element ist starr an das lateral auslenkbare Element angebunden. Aufgrund der im Vergleich zu dem lateral auslenkbaren Element geringeren Masse des passiven Elements können gerade bei Richtungswechseln der lateralen Bewegung des aus dem passiven Element sowie dem lateral auslenkbaren Elements gebildeten Systems höhere Beschleunigungen erreicht werden, so dass das System konstantere Geschwindigkeiten über den Auslenkungsbereich erzielen kann. Dies ermöglicht höhere Resonanzfrequenzen für die laterale Bewegung und erlaubt es, mit größeren Mengen an Umgebungsfluid zu interagieren. Das aus dem passiven Element sowie dem lateral auslenkbaren Element gebildete System ermöglicht zudem große jeweilige Volumina für die erste und die zweite Teilkavität, so dass nur ein vergleichsweise geringer (ungewollter) elektrischer Kapazitätsbelag erfolgt.

### Figurenkurzbeschreibung

Einige Beispiele von Vorrichtungen und/oder Verfahren werden nachfolgend bezugnehmend auf die beiliegenden Figuren lediglich beispielhaft näher erläutert. Es zeigen:
Fig. 1 eine Draufsicht auf ein erstes Ausführungsbeispiel eines MEMS-Bauteil;
Fig. 2 eine Schnittansicht entlang der Schnittachse A-A durch das erste Ausführungsbeispiel des MEMS-Bauteils;
Fig. 3 eine Schnittansicht entlang der Schnittachse B-B durch das erste Ausführungsbeispiel des MEMS-Bauteils;
Fig. 4 eine Schnittansicht entlang der Schnittachse E-E durch das erste Ausführungsbeispiel des MEMS-Bauteils;
Fig. 5 eine Draufsicht auf ein zweites Ausführungsbeispiel eines MEMS-Bauteil;
Fig. 6 eine Schnittansicht entlang der Schnittachse C-C durch das zweite Ausführungsbeispiel des MEMS-Bauteils;
Fig. 7 eine Schnittansicht entlang der Schnittachse D-D durch das zweite Ausführungsbeispiel des MEMS-Bauteils;
Fig. 8 eine Draufsicht auf ein drittes Ausführungsbeispiel eines MEMS-Bauteil;
Figs. 9 und 10 Ausführungsbeispiele des passiven Elements;
Fig. 11 eine Draufsicht auf ein viertes Ausführungsbeispiel eines MEMS-Bauteil;
Fig. 12 ein Ausführungsbeispiel einer Baugruppe mit zumindest einem MEMS-Bauteil;
Fig. 13 ein Ablaufdiagramm eines ersten Ausführungsbeispiels eines Verfahrens zum Betreiben eines MEMS-Bauteils; und
Fig. 14 ein Ablaufdiagramm eines zweiten Ausführungsbeispiels eines Verfahrens zum Betreiben eines MEMS-Bauteils.

### Beschreibung

Verschiedene Beispiele werden nun ausführlicher Bezug nehmend auf die beiliegenden Figuren beschrieben, in denen einige Beispiele dargestellt sind. In den Figuren können die Stärken von Linien, Schichten und/oder Bereichen zur Verdeutlichung übertrieben sein.

Während sich weitere Beispiele für verschiedene Modifikationen und alternative Formen eignen, sind dementsprechend einige bestimmte Beispiele derselben in den Figuren gezeigt und werden nachfolgend ausführlich beschrieben. Allerdings beschränkt diese detaillierte Beschreibung weitere Beispiele nicht auf die beschriebenen bestimmten Formen. Weitere Beispiele können alle Modifikationen, Entsprechungen und Alternativen abdecken, die in den Rahmen der Offenbarung fallen. Gleiche oder ähnliche Bezugszeichen beziehen sich in der gesamten Beschreibung der Figuren auf gleiche oder ähnliche Elemente, die bei einem Vergleich miteinander identisch oder in modifizierter Form implementiert sein können, während sie die gleiche oder eine ähnliche Funktion bereitstellen.

Es versteht sich, dass, wenn ein Element als mit einem anderen Element "verbunden" oder "gekoppelt" bezeichnet wird, die Elemente direkt, oder über ein oder mehrere Zwischenelemente, verbunden oder gekoppelt sein können. Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht explizit oder implizit anders definiert. Eine alternative Formulierung für die gleichen Kombinationen ist "zumindest eines von A und B" oder "A und/oder B". Das Gleiche gilt, mutatis mutandis, für Kombinationen von mehr als zwei Elementen.

Die Terminologie, die hier zum Beschreiben bestimmter Beispiele verwendet wird, soll nicht begrenzend für weitere Beispiele sein. Wenn eine Singularform, z. B. "ein, eine" und "der, die, das" verwendet wird und die Verwendung nur eines einzelnen Elements weder explizit noch implizit als verpflichtend definiert ist, können weitere Beispiele auch Pluralelemente verwenden, um die gleiche Funktion zu implementieren. Wenn eine Funktion nachfolgend als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei Gebrauch das Vorhandensein der angegebenen Merkmale, Ganzzahlen, Schritte, Operationen, Prozesse, Elemente, Komponenten und/oder einer Gruppe derselben präzisieren, aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

Sofern nicht anderweitig definiert, werden alle Begriffe (einschließlich technischer und wissenschaftlicher Begriffe) hier in ihrer üblichen Bedeutung auf dem Gebiet verwendet, zu dem Beispiele gehören.

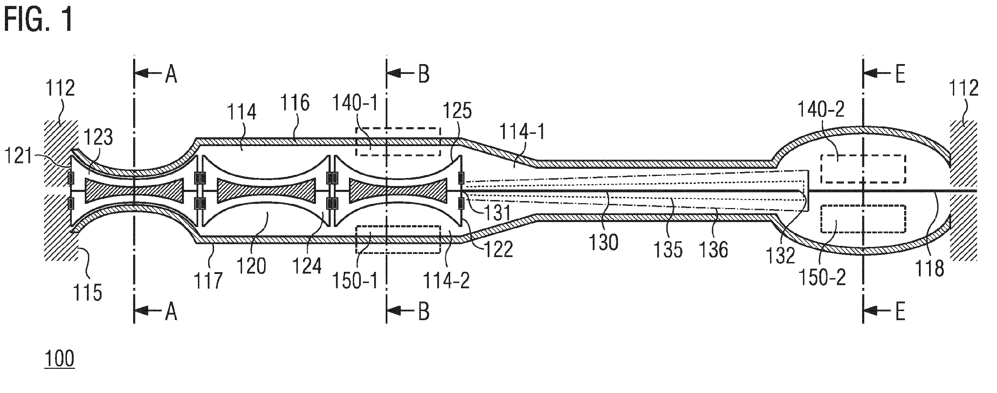

**Fig. 1** zeigt eine Draufsicht auf ein erstes MEMS-Bauteil 100. Insbesondere zeigt Fig. 1 eine Draufsicht auf eine zweite Schicht 112 eines Schichtstapels 110, aus dem das MEMS-Bauteil 100 aufgebaut bzw. herausgebildet ist. Der Aufbau des Schichtstapels 110 ist aus

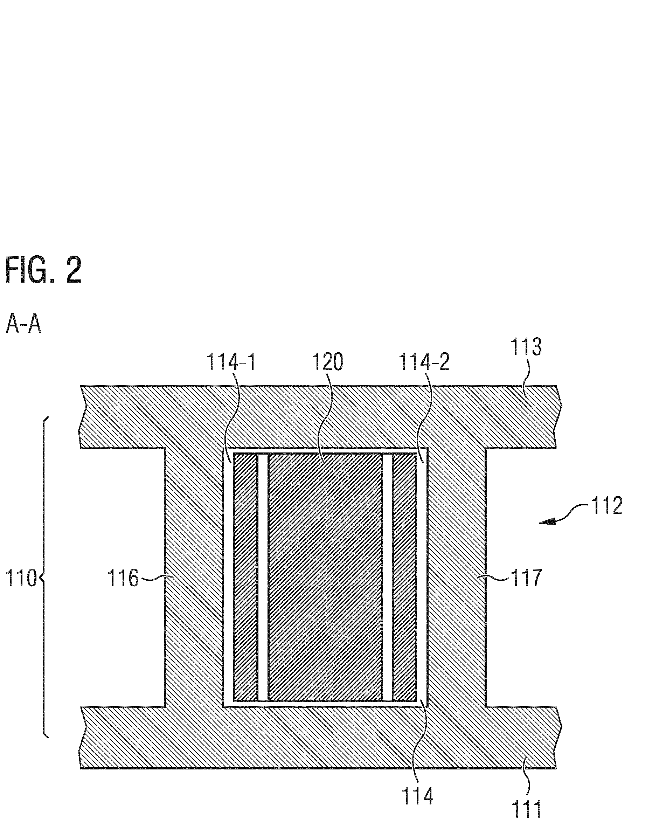

**Fig. 2** ersichtlich, in der eine Schnittansicht des MEMS-Bauteils 100 entlang der in Fig. 1 angedeuteten Schnittlinie A-A dargestellt ist.

Aus Fig. 2 ist ersichtlich, dass der Schichtstapel 110 zumindest eine erste Schicht 111, die zweite Schicht 112 und eine dritte Schicht 113 umfasst. Die zweite Schicht 112 ist dabei zwischen der ersten Schicht 111 und der dritten Schicht 113 gebildet. In der zweiten Schicht 112 (welche auch als Deviceebene, Deviceschicht oder Devicewafer aufgefasst werden kann) ist zumindest eine erste Kavität 114 gebildet, in der die weiteren Elemente des MEMS-Bauteils 100 angeordnet sind. Die zweite Schicht 112 kann daher auch als eine Substratschicht aufgefasst werden. Optional können weitere Kavitäten in der zweiten Schicht 112 gebildet sein.

Die erste Schicht 111 dient als Bodenschicht für die zweite Schicht 112 (und kann auch als ein Handlingwafer aufgefasst werden). Die dritte Schicht 113 dient als Deckelschicht für die zweite Schicht 112 (und kann auch als Deckelwafer aufgefasst werden). Die erste Schicht 111 und die dritte Schicht 113 begrenzen die erste Kavität 114 entlang der Dickenrichtung des Schichtstapels 110.

Die Schichten 111 bis 113 können elektrisch leitfähige Materialien aufweisen wie etwa dotierte Halbleitermaterialien (z.B. dotiertes Silizium) oder Metallmaterialien. Ferner können die Schichten 111 bis 113 beschichtete Oberflächen aufweisen (z.B. Metall auf undotiertem Silizium oder Polymeren). Die schichtweise Anordnung elektrisch leitfähiger Schichten ermöglicht eine einfache Ausgestaltung bzw. Strukturierung, da durch selektives Herauslösen von Material aus der jeweiligen Schicht aktive Elemente (z.B. Elektroden) wie auch passive Elemente gebildet werden können. Ebenso können die Schichten 111 bis 113 elektrisch nicht-leitfähige Materialien aufweisen. Die elektrisch nicht-leitfähigen Materialien können beispielsweise mittels Abscheideverfahren in einer der Schichten 111 bis 113 eingebracht werden.

Beispielsweise können die erste Schicht 111, die zweite Schicht 112 und die dritte Schicht 113 jeweils ein Wafer sein. Die einzelnen Wafer sind über stoffschlüssige Verfahren (z.B. Bonden) jeweils paarweise miteinander verbunden, um den Schichtstapel 110 mit der oben beschriebenen Schichtenfolge zu erhalten. Entsprechend kann die erste Kavität 114 als ein akustisch abgedichteter Zwischenraum in dem MEMS-Bauteil 100 ausgebildet werden.

In der ersten Kavität 114 ist ein lateral auslenkbares Element 120 angeordnet, das ein mit einer Seitenwand 115 der ersten Kavität 114 verbundenes Ende 121 sowie ein freies Ende (bzw. ein frei bewegliches Ende) 122 aufweist. Mit anderen Worten: Das lateral auslenkbare Element 120 ist mit dem umgebenden Substrat einseitig verbunden. Der Begriff "lateral auslenkbar" ist dabei so zu verstehen, dass das lateral auslenkbares Element 120 in der Lage ist, eine Bewegung in der Ebene der zweiten Schicht 112, d.h. eine in-plane Bewegung, durchzuführen. Mit anderen Worten: Das lateral auslenkbare Element 120 kann sich innerhalb der Ebene der zweiten Schicht 112, jedoch nicht vertikal zur Ebene der zweiten Schicht 112 (d.h. aus der Ebene der zweiten Schicht 112 heraus) bewegen.

Das lateral auslenkbare Element 120 kann verschiedenartig ausgebildet bzw. aufgebaut sein. Unabhängig vom konkreten Aufbau des lateral auslenkbaren Elements 120 ist dieses ausgebildet, sich bei Anlegen eines ersten Potentials (z.B. eines ersten Spannungssignals als Ansteuerungssignal) lateral zu verformen und/oder bei lateraler Verformung aufgrund einer äußeren Krafteinwirkung ein zweites Potential (z.B. ein zweites Spannungssignal als Auswertungssignal) auszugeben. Mit anderen Worten: Das lateral auslenkbare Element 120 ist ausgebildet, um ansprechend auf eine Aktuierung eine Kraft über eine Bewegung bzw. Verformung bereitzustellen (d.h. als Aktor zu wirken) und/oder um eine Kraft mittels Verformung zu erfassen (d.h. als Sensor zu wirken). Beispielsweise kann das lateral auslenkbares Element 120 als elektromechanischer Wandler, piezoelektrischer Wandler, magnetostriktiver Wandler, thermomechanischer Wandler oder eine Kombination daraus ausgebildet sein, um die jeweilige Energieform bzw. das jeweilige Potential in mechanische Energie zu wandeln und umgekehrt. Basierend auf einem jeweils angelegten Potential kann so eine entsprechende Verformung des lateral auslenkbaren Elements 120 in der Ebene der zweiten Schicht 112 bereitgestellt werden bzw. bei lateraler Verformung aufgrund einer äußeren Krafteinwirkung durch das lateral auslenkbare Element 120 ein entsprechendes Potential bereitgestellt werden.

Das in Figs. 1 und 2 dargestellte lateral auslenkbare Element 120 ist als elektrostatischer Wandler ausgebildet und weist einander gegenüberliegende, erste, zweite und dritte auslenkbare bzw. lateral verformbare Teilelemente 123, 124 und 125 auf, die voneinander beabstandet und elektrisch miteinander verbunden sind. Die lateral verformbaren Teilelemente 123, 124 und 125 weisen dabei jeweils eine konkav gekrümmte Form auf. Mit anderen Worten: Das lateral auslenkbare Element 120 ist in Fig. 1 als dreizelliges, balanciertes Element ausgebildet. Jedes der lateral verformbaren Teilelemente 123, 124 und 125 ist im einfachsten Fall dreischichtig aufgebaut mit zwei geometrisch unterschiedlich ausgebildeten Elektrodenschichten, die über eine nichtleitende Schicht, die unterbrochen sein kann, miteinander verbunden sind. Bei Anlegen eines Potentials zwischen den zumindest zwei Elektrodenschichten wird ein elektrisches Feld aufgespannt, infolgedessen sich die Elektrodenschichten (z.B. unter Veränderung ihrer Länge) lateral verformen. Aufgrund der mechanischen Fixierung des lateral auslenkbaren Elements 120 an der Seitenwand 115 der Kavität 114 sind die Freiheitsgrade der resultierenden Verformung eingegrenzt, so dass eine Verformung (Verkrümmung bzw. Auslenkung) in der Ebene der zweiten Schicht 112 erfolgt. Die Verwendung jeweils dreier lateral verformbarer Teilelemente 123, 124 und 125 für das lateral auslenkbare Element 120 ermöglicht eine hohe und einstellbare Linearität des lateral auslenkbaren Elements 120.

Auslenkbare Elemente und insbesondere lateral auslenkbare Elemente, die zumindest eine erste Elektrodenschicht und eine zweite Elektrodenschicht, zwischen denen eine nicht-leitende Schicht ausgebildet ist, umfassen, sind auch als nanoskopische elektrostatische Antriebe (engl. Nanoscopic Electrostatic Drive, NED) bekannt. Ausführungsbeispiele für NEDs sind in den Patentanmeldungen WO 2012/095185 A1, WO 2016/202790 A2 und DE 10 215/206 774 A1 der Fraunhofer-Gesellschaft zur Förderung der angewandten Wissenschaften beschrieben.

Laterale NEDs (L-NEDs) verformen sich lateral bei Anlegen eines ersten Spannungssignals an die erste Elektrodenschicht und die zweite Elektrodenschicht. Ferner erzeugen L-NEDs bei lateraler Verformung aufgrund einer äußeren Krafteinwirkung ein zweites Spannungssignal an der ersten Elektrodenschicht und der zweiten Elektrodenschicht. Das lateral auslenkbare Element 120 kann somit gemäß einigen Ausführungsbeispielen als NED ausgebildet sein. DE 10 2017 203722 A1 offenbart ein MEMS mit einem Substrat, das eine Kavität aufweist. Das MEMS umfasst ein in der Kavität angeordnetes bewegliches Element umfassend eine erste Elektrode, eine zweite Elektrode und eine zwischen der ersten und zweiten Elektrode angeordnete und von denselben an diskreten Bereichen elektrisch isoliert fixierte dritte Elektrode. Das bewegliche Element ist ausgebildet, um ansprechend auf ein elektrisches Potential zwischen der ersten Elektrode und der dritten Elektrode und/oder um ansprechend auf ein elektrisches Potential zwischen der zweiten Elektrode und der dritten Elektrode eine Bewegung entlang einer Bewegungsrichtung in einer Substratebene auszuführen.

Wie aus den weiteren Ausführungsbeispielen ersichtlich sein wird, ist die Form des lateral auslenkbaren Elements 120 nicht auf die in Fig. 1 gezeigte, konkav gekrümmte Form beschränkt. Grundsätzlich kann die Form des lateral auslenkbaren Elements 120 beliebig sein (z.B. balkenartig, dachartig, etc.). Beispielsweise kann das lateral auslenkbare Element 120 alternativ als zweizelliges, balanciertes Element oder als ein balkenförmiges Element, das aus zumindest zwei zueinander beabstandeten Elektroden aufgebaut ist, ausgebildet sein.

Ein passives Element 130 ist starr (d.h. fest bzw. nicht beweglich bzw. nicht elastisch) an das freie Ende 122 des lateral auslenkbaren Elements 120 angebunden, um einer Bewegung des lateral auslenkbaren Elements 120 zu folgen. Das passive Element 130 kann sich im Gegensatz zu dem lateral auslenkbaren Element 120 nicht verformen und ist insofern "passiv". Das passive Element 130 kann aus einer Vielzahl an Materialen ausgebildet sein. Beispielsweise kann das passive Element 130 aus dem gleichen Material wie die zweite Schicht 112 gebildet sein.

Zwei mögliche laterale Auslenkungsbereiche des passiven Elements 130 sind in Fig. 1 angedeutet. Zum einen ist ein Auslenkungsbereich 135 für eine quasistatische Anregung des lateral auslenkbaren Elements 120 (d.h. für einen quasistatischen Fall) in Fig. 1 dargestellt, und zum anderen ist ein Auslenkungsbereich 136 für eine resonante Anregung des lateral auslenkbaren Elements 120 (d.h. für einen resonanten Fall) in Fig. 1 dargestellt.

Gemäß Ausführungsbeispielen ist eine Steifigkeit des passiven Elements 130 größer oder gleich einer Steifigkeit des lateral auslenkbaren Elements 120. Mit anderen Worten: Die Steifigkeit des passiven Elements 130 ist zumindest vergleichbar zu der des lateral auslenkbaren Elements 120.

Lateral ist die erste Kavität 114 ferner durch zwei weitere Seitenwände 116 und 117 begrenzt. Die weiteren Seitenwände 116 und 117 können als Berandung der ersten Kavität 114 aufgefasst werden. Das lateral auslenkbare Element 120 als auch das passive Element 130 erstrecken sich jeweils entlang ihrer Längserstreckung zwischen den zwei weiteren Seitenwänden 116 und 117. Wie insbesondere aus dem linken Teil von Fig. 1 ersichtlich ist, sind die jeweiligen Verläufe der weiteren Seitenwände 116 und 117 zumindest zum Teil an eine Außenkontur des lateral auslenkbaren Elements 120 angepasst.

In der ersten Kavität 114 ist ferner eine T-förmige Trennwand 118 gebildet. Die Trennwand 118 unterteilt zusammen mit dem lateral auslenkbaren Element 120 und dem passiven Element 130 die erste Kavität 114 in eine erste Teilkavität 114-1 und eine zweite Teilkavität 114-2. Zwischen der Trennwand 118 und dem freien Ende 132 des passiven Elements 130 ist ein Spalt gebildet ist, um eine Bewegung des passiven Elements 130 relativ zu der Trennwand 118 zu ermöglichen. Der Spalt ist dabei jedoch so gering, dass ein (signifikanter) Volumenstrom des Umgebungsfluides durch den Spalt nicht möglich ist. Mit anderen Worten: Zwischen der Trennwand 118 und dem freien Ende 132 des passiven Elements 130 ist ein (kleiner) Freiraum gebildet, dessen Abmessungen so gering sind, dass durch den Freiraum kein (signifikanter) Volumenstrom zwischen den benachbarten Teilkavitäten 114-1 und 114-2 möglich ist. Beispielsweise kann der Abstand zwischen dem der Trennwand 118 und dem freien Ende 132 des passiven Elements 130 weniger als 10 µm, 5 µm oder 3 µm betragen.

Jede der Teilkavitäten 114-1 und 114-2 steht über zumindest eine jeweilige Öffnung mit einem Umgebungsfluid (z.B. ein Gas oder Flüssigkeit), welches das MEMS-Bauteil 100 umgibt, in Kontakt. Die erste Teilkavität 114-1 steht über zumindest eine erste Öffnung 140-1 mit dem Umgebungsfluid des MEMS-Bauteils 100 in Kontakt. Die zweite Teilkavität 114-2 steht über zumindest eine zweite Öffnung 150-1 mit dem Umgebungsfluid des MEMS-Bauteils 100 in Kontakt. Bei dem in Fig. 1 dargestellten MEMS-Bauteil 100 steht die erste Teilkavität 114-1 über zwei erste Öffnungen 140-1 und 140-2 mit dem Umgebungsfluid des MEMS-Bauteils 100 in Kontakt. Eine der zwei ersten Öffnungen, nämliche die erste Öffnung 140-1 ist in einem Bereich der ersten Teilkavität 114-1 angeordnet, in dem sich das lateral auslenkbare Element 120 erstreckt. Die andere der zwei ersten Öffnungen, nämlich die erste Öffnung 140-2, ist in einem davon verschiedenen Bereich der ersten Teilkavität 114-1 angeordnet ist. In dem in Fig. 1 dargestellten Ausführungsbeispiel ist die erste Öffnung 140-2 im Bereich der Trennwand 118 am freien Ende 132 des passiven Elements 130 angeordnet. In äquivalenter Weise ist die zweite Teilkavität 114-2 über zwei zweite Öffnungen 150-1 und 150-2 mit dem Umgebungsfluid des MEMS-Bauteils 100 in Kontakt. Dabei ist zu beachten, dass die Anzahl der ersten bzw. Öffnungen frei gewählt werden kann. Beispielsweise können für jede der Teilkavitäten jeweils n = 1, 2, 3 oder mehr Öffnung vorgesehen sein. Auch kann die Platzierung der Öffnung frei, insbesondere verschieden zu den in Fig. 1 dargestellten Positionen gewählt (z.B. im Bereich des freien Endes 132 des passiven Elements 130), werden.

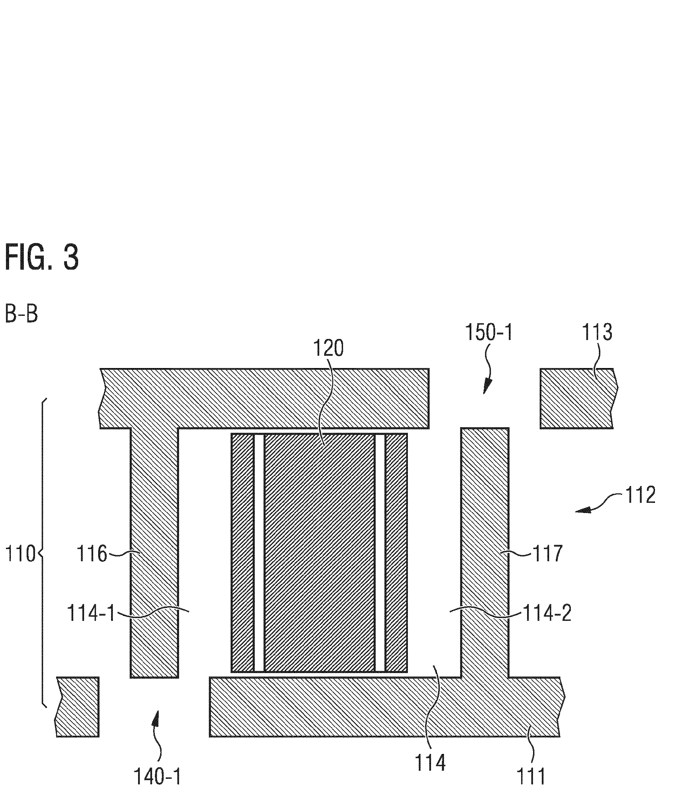

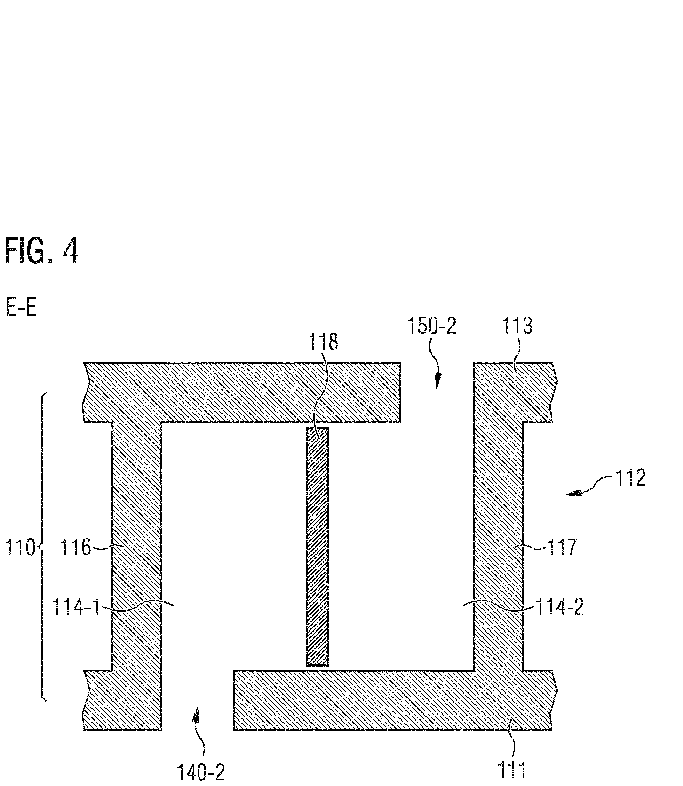

Die zumindest eine erste Öffnung 140-1 ist dabei in einer anderen Schicht der ersten Schicht 111 und der dritten Schicht 113 als die zumindest eine zweite Öffnung 150-1 gebildet. Dies ist beispielsweise aus **Fig. 3** und **Fig. 4** ersichtlich, die jeweils eine Schnittansicht des MEMS-Bauteils 100 entlang der in Fig. 1 angedeuteten Schnittlinien B-B und E-E darstellen. Bei dem in Fig. 3 und Fig. 4 gezeigten Ausführungsbeispiel sind die ersten Öffnungen 140-1 und 140-2 in der ersten Schicht 111 gebildet, währen die zweiten Öffnungen 150-1 und 150-2 in der dritten Schicht 113 gebildet sind. Derart kann ein akustischer Kurzschluss zwischen benachbarten Teilkavitäten der ersten Kavität 114 vermieden werden. Es ist zu beachten, dass die ersten Öffnungen 140-1 und 140-2 alternativ auch in der dritten Schicht 113 gebildet sein können und die zweiten Öffnungen 150-1 und 150-2 entsprechend in der ersten Schicht 111 gebildet sein können.

Die zumindest eine erste Öffnung und die zumindest eine zweite Öffnung sind dabei so angeordnet, dass das lateral auslenkbare Element 120 und das passive Element 130 die Öffnungen selbst bei maximaler lateraler Auslenkung nicht überdecken können, um einen akustischen Kurzschluss der beiden Teilkavitäten 114-1 und 114-2 zu vermeiden. Es erfolgt (im Wesentlichen) kein Austausch von Fluid zwischen der ersten Teilkavität 114-1 und der zweiten Teilkavität 114-2 aufgrund der Unterteilung der ersten Kavität 114 durch das lateral auslenkbare Element 120, das passive Element 130 und die Trennwand 118.

Über eine laterale Bewegung des lateral auslenkbaren Elements 120 und des passiven Elements 130 können die Volumina der Teilkavitäten 114-1 und 114-2 verändert werden. Die volumenveränderlichen Teilkavitäten 114-1 und 114-2 dienen zur Interaktion mit dem Umgebungsfluid. Über die zumindest eine erste Öffnung 140-1 und die zumindest eine zweite Öffnung 150-1 erfolgt ein Druckausgleich in den Teilkavitäten 114-1 und 114-2 bei einer Volumenveränderung.

Wie bereits oben ausgeführt, ist das lateral auslenkbare Element 120 ausgebildet, sich bei Anlegen eines ersten Potentials lateral zu verformen, so dass sich das lateral auslenkbare Element 120 und das passive Element 130 gegenüber den weiteren Seitenwänden 116 und 117 der ersten Kavität 114 bewegen, um zur Beeinflussung des Umgebungsfluid das Volumen der ersten Teilkavität 114-1 abwechselnd zu verringern und zu vergrößern und umgekehrt das Volumen der zweiten Teilkavität 114-2 abwechselnd zu vergrößern bzw. zu verringern. Über die Öffnungen 140-1 und 140-2 bzw. 150-1 und 150-2 wirken die Änderung der Volumina der Teilkavitäten 114-1 und 114-2 auf das in der Umgebung des MEMS-Bauteils 100 vorhandene Umgebungsfluid und beeinflussen dieses dadurch. Entsprechend wirkt das MEMS-Bauteil 100 als Aktor.

Umgekehrt können sich das lateral auslenkbare Element 120 und das passive Element 130 gegenüber den weiteren Seitenwänden 116 und 117 der ersten Kavität 114 lateral bewegen, um abhängig von dem Umgebungsfluid Volumina der ersten Teilkavität 114-1 und der zweiten Teilkavität 114-2 unter Verformung des lateral auslenkbaren Elements 120 einzustellen. Beispielsweise kann abhängig von Druckverhältnissen bzw. Druckgradienten im Umgebungsfluid das Volumen der ersten Teilkavität 114-1 verringert und das Volumen der zweiten Teilkavität 114-2 vergrößert werden, so dass das lateral auslenkbare Element 120 und das passive Element 130 gegenüber den weiteren Seitenwänden 116 und 117 der ersten Kavität 114 lateral verschoben werden und das lateral auslenkbare Element 120 entsprechend verformt wird. Wie oben ausgeführt, ist das lateral auslenkbare Element 120 ausgebildet, bei lateraler Verformung aufgrund einer äußeren Krafteinwirkung durch die Verschiebung des lateral auslenkbaren Elements 120 und des passiven Elements 130 gegenüber den weiteren Seitenwänden 116 und 117 der ersten Kavität 114 ein zweites Potential auszugeben.

Umfasst das lateral auslenkbare Element 120 wie oben beschrieben z.B. eine erste Elektrodenschicht und eine zweite Elektrodenschicht, zwischen denen eine nicht-leitende Schicht ausgebildet ist, kann das lateral auslenkbare Element 120 entsprechend ausgebildet sein, sich bei Anlegen eines ersten Spannungssignals (als Beispiel für ein erstes Potential) an die erste Elektrodenschicht und die zweite Elektrodenschicht lateral zu verformen, und/oder bei lateraler Verformung aufgrund einer äußeren Krafteinwirkung ein zweites Spannungssignal (als Beispiel für ein zweites Potential) an der ersten Elektrodenschicht und der zweiten Elektrodenschicht zu erzeugen.

Die Kombination aus lateral auslenkbarem Element 120 und passivem Element 130 bildet insgesamt eine große Fläche für die Interaktion mit dem Umgebungsfluid. Das MEMS-Bauteil 100 kann somit eine vergrößerte fluidische Wirkfläche bereitstellen. Das MEMS-Bauteil 100 kann dabei sowohl zur Beeinflussung des Umgebungsfluides, d.h. als Aktor, als auch zur Vermessung des Umgebungsfluides, d.h. als Sensor, genutzt werden. Aufgrund der vorbeschriebenen Ausgestaltung weist das passive Element 130 eine vergleichsweise geringe Masse auf, so dass gerade bei Richtungswechseln der lateralen Bewegung hohe Beschleunigungen erreicht werden können und sich innerhalb des Auslenkungsbereichs des Wandlers entsprechend der Anteil des Auslenkungsbereichs, den der Wandler mit konstanterer Geschwindigkeit überschreitet, erhöht. Dies wirkt sich positiv auf die für die laterale Bewegung erreichbaren Resonanzfrequenzen aus. Ferner kann dadurch mit einer größeren Menge an Umgebungsfluid interagiert werden.

Die geringen Abmessungen des passiven Elements 130 im Vergleich zu dem lateral auslenkbaren Element 120 ermöglichen große Volumina der Teilkavitäten 114-1 und 114-2.

Derart können hohe Packungsdichten bei großer fluidischer Wirkfläche ermöglicht werden. Gleichzeitig verringert sich dadurch in vorteilhafter Weise der Kapazitätsbelag des MEMS-Bauteils bzw. Wandlersystems. (d.h. die elektrische Kapazität die eine spezifische Chipoberfläche des MEMS-Bauteils innehat).

Eine Erstreckung des passiven Elements 130 entlang einer Dickenrichtung der zweiten Schicht 112 ist in einigen Ausführungsbeispielen gleich zu einer Erstreckung des lateral auslenkbaren Elements 120 entlang der Dickenrichtung der zweiten Schicht 112. Mit anderen Worten: Die Höhe des passiven Elements 130 kann gleich zu einer Höhe des lateral auslenkbaren Elements 120 sein. Alternativ kann die Erstreckung des passiven Elements 130 entlang der Dickenrichtung der zweiten Schicht 112 zumindest teilweise geringer als die Erstreckung des lateral auslenkbaren Elements 120 entlang der Dickenrichtung der zweiten Schicht 112 sein. Beispielsweise kann die Erstreckung des passiven Elements 130 entlang der Dickenrichtung der zweiten Schicht 112 zumindest teilweise 5 bis 10 µm geringer sein als die Erstreckung des lateral auslenkbaren Elements 120 entlang der Dickenrichtung der zweiten Schicht 112. Eine geringere Höhe des passiven Elements 130 im Vergleich zu dem lateral auslenkbaren Element 120 kann eine Anpassung der fluidischen Last auf die Leistungsfähigkeit des lateral auslenkbaren Elements 120 ermöglichen. Ebenso kann über die Höhe eine Angleichung der Fluidsteifigkeit an die Steifigkeit des lateral auslenkbaren Elements 120 erfolgen. Dies könnte alternativ auch über eine Variation der Längserstreckung des passiven Elements 130 erfolgen. Die Variation der Höhenerstreckung des passiven Elements 130 hat gegenüber der Variation der Längserstreckung den Vorteil, dass der Füllfaktor der ersten Kavität 114 erhalten bleibt (d.h. das Volumen der ersten Kavität muss nicht verändert werden).

Die Erstreckungen des passiven Elements 130 als auch des lateral auslenkbaren Elements 120 entlang der Dickenrichtung der zweiten Schicht 112 sind dabei so gewählt, dass jeweils nur ein geringer Spalt zwischen dem passiven Element 130 bzw. dem lateral auslenkbaren Element 120 und der ersten Schicht 111 (d.h. dem Handlingwafer) bzw. der dritten Schicht 113 (d.h. dem Deckelwafer) verbleibt. Insbesondere sind die Erstreckungen des passiven Elements 130 als auch des lateral auslenkbaren Elements 120 entlang der Dickenrichtung der zweiten Schicht 112 so gewählt, dass durch den Freiraum zwischen dem passiven Element 130 bzw. dem lateral auslenkbaren Element 120 und der ersten Schicht 111 bzw. der dritten Schicht 113 kein (signifikanter) Volumenstrom zwischen den benachbarten Teilkavitäten 114-1 und 114-2 möglich ist. Beispielsweise kann der Abstand zwischen dem passiven Element 130 bzw. dem lateral auslenkbaren Element 120 und der ersten Schicht 111 bzw. der dritten Schicht 113 weniger als 10 µm, 5 µm oder 3 µm betragen. Entsprechend kann ein akustischer Kurzschluss zwischen den Teilkavitäten 114-1 und 114-2 vermieden werden.

Wie insbesondere aus Fig. 1 ersichtlich ist, ist ein Querschnitt des passiven Elements 130 entlang seiner Längserstreckung kleiner als ein Querschnitt des lateral auslenkbaren Elements 120 entlang seiner Längserstreckung. Mit anderen Worten: In Bewegungsrichtung des lateral auslenkbaren Elements 120 (d.h. in lateraler Richtung) ist die geometrische Ausbreitung des passiven Elements 130 (deutlich) geringer als die geometrische Ausbreitung des lateral auslenkbaren Elements 120.

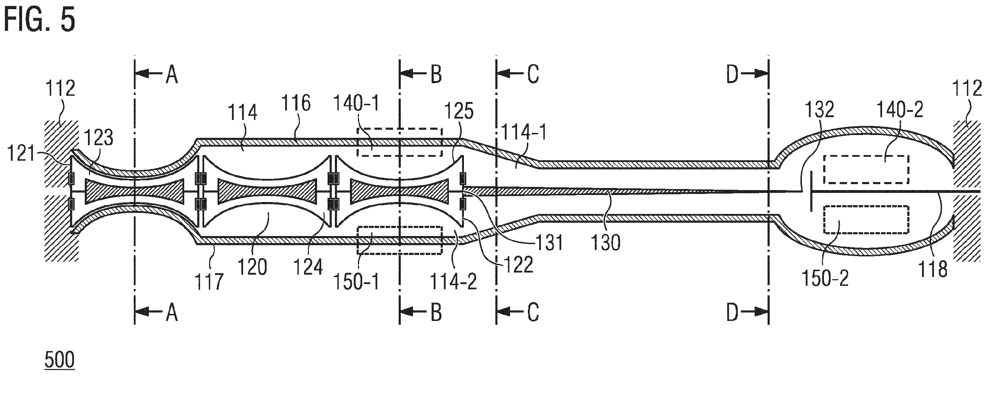

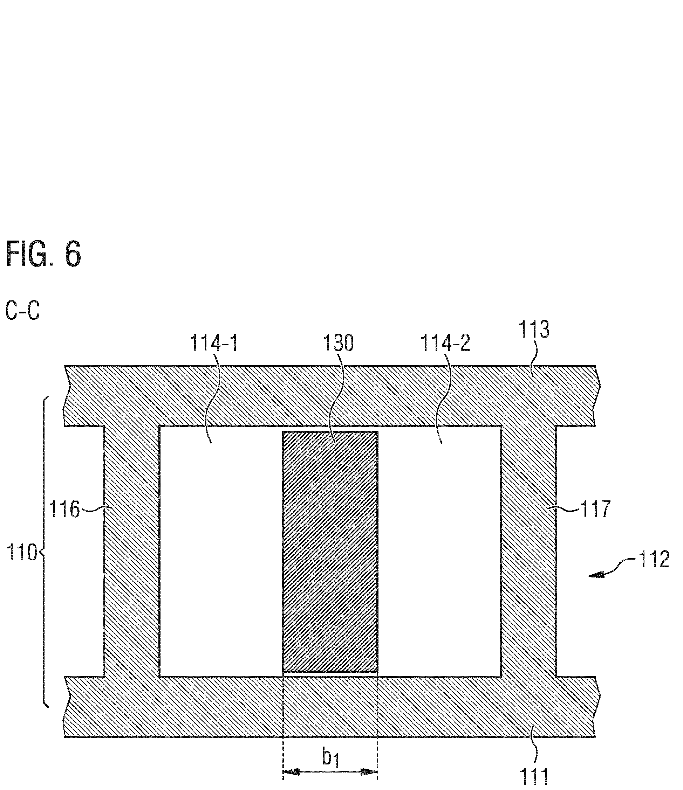

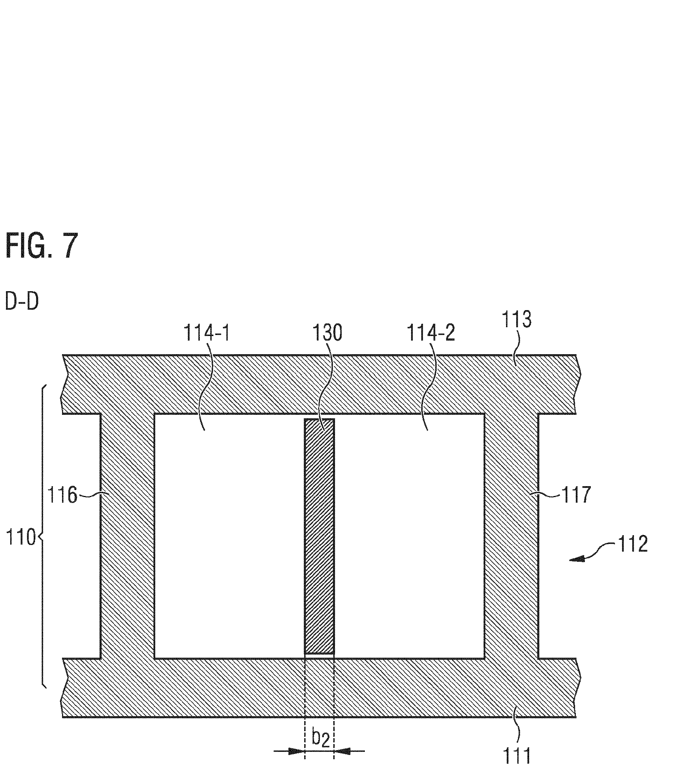

Der Querschnitt des passiven Elements 130 entlang seiner Längserstreckung kann wie in Fig. 1 dargestellt konstant (d.h. unverändert) sein. Alternativ kann sich der Querschnitt des passiven Elements 130 entlang seiner Längserstreckung auch ändern. Dies ist in Fig. 5 dargestellt. Bei dem in Fig. 5 dargestellten MEMS-Bauteil 500 nimmt der Querschnitt des passiven Elements 130 von dem mit dem lateral auslenkbaren Element 120 verbundenen Ende 131 des passiven Elements 130 hin zu einem freien Ende 132 des passiven Elements 130 ab, ansonsten ist das MEMS-Bauteil 500 identisch zu dem MEMS-Bauteil 100 aufgebaut. Mit anderen Worten: Das passive Element 130 verjüngt sich von dem mit dem lateral auslenkbaren Element 120 verbundenen Ende 131 hin zu dem freien Ende 132 des passiven Elements 130. Die Verbindungsstelle des passiven Elements 130 zum lateral auslenkbaren Element 120 weist somit die größten geometrischen Abmessungen auf, während das frei schwingende Ende 132 des passiven Elements 130 die geringsten geometrischen Abmessungen aufweist. Beispielsweise kann das passive Element 130 in der Ebene der zweiten Schicht 112 spitz zu laufen, wobei das spitze Ende des passiven Elements 130 das freie Ende 132 des passiven Elements 130 ist. Dies ist ferner aus **Fig. 6** und **Fig. 7** ersichtlich, die jeweils eine Schnittansicht des MEMS-Bauteils 500 entlang der in Fig. 5 angedeuteten Schnittlinien C-C und D-D darstellen. Während die Breite (d.h. die laterale Erstreckung) des passiven Elements 130 an der Schnittlinie C-C noch b₁ beträgt, so beträgt die Breite des passiven Elements 130 an der Schnittline D-D, welche dem freien Ende 132 des passiven Elements 130 näher ist als die Schnittlinie C-C, nur mehr b₂ (wobei b₂ < b₁). Die größere Breite des passiven Elements 130 im Verbindungsbereich zwischen dem passiven Element 130 und dem lateral auslenkbaren Element 120 im Vergleich zur Breits am freien Ende 132 des passiven Elements 130 ermöglicht einen homogenen Spannungsübergang zwischen dem freien Ende 122 des lateral auslenkbaren Elements 120 und dem passiven Element 130. Die Spannungen, die aus dem Widerstand des passiven Elements 130 gegenüber dem Umgebungsfluid und der Trägheit des passiven Elements 130 bei Änderung der Beschleunigung resultieren, können aufgrund der größeren Breite am Ende 131 des passiven Elements 130 homogen in das lateral auslenkbare Element 120 übertragen werden. Die aufgrund der Verjüngung des passiven Elements 130 reduzierte Masse bzw. Trägheit des passiven Elements 130 verbessert das dynamische Verhalten des aus passivem Element 130 und lateral auslenkbarem Element 120 gebildeten Wandlersystems.

Unabhängig davon, ob der Querschnitt des passiven Elements 130 sich entlang der Längserstreckung des passiven Elements 130 ändert oder konstant ist, ist das Verhältnis der Längserstreckung des passiven Elements 130 zu seiner Lateralerstreckung größer als z.B. 10:1, 20:1, 30:1, 40:1 oder 50:1. Mit anderen Worten: Das passive Element 130 ist wesentlich länger als breit und kann daher auch als "stabförmiges" Element aufgefasst werden.

Die Längserstreckung des passiven Elements 130 kann abhängig von dem gewünschten dynamischen Verhalten des Systems aus passivem Element 130 und lateral auslenkbarem Element 120 gewählt werden. Die erreichbare Resonanzfrequenz des Systems aus passivem Element 130 und lateral auslenkbarem Element 120 kann über die Wahl der Länge des passiven Elements 130 eingestellt werden. Dabei ist zu beachten, dass die erreichbare Resonanzfrequenz mit zunehmender Länge des passiven Elements 130 abnimmt. Beispielsweise kann eine Längserstreckung des passiven Elements zwischen 20 % und 160 %, insbesondere zwischen 30 % und 50 % oder zwischen 60 % und 100% oder auch 80 %, einer Längserstreckung des lateral auslenkbaren Elements 120 betragen.

Wie bereits bei der Beschreibung der einzelnen Elemente der MEMS-Bauteile 100 und 500 mehrfach angedeutet, können die einzelnen Elemente eines MEMS-Bauteils gemäß der vorgeschlagenen Architektur gegenüber den in Fig. 1 und Fig. 5 dargestellten MEMS-Bauteilen 100 und 500 auf vielfache Weise abgewandelt sein. Nachfolgend werden daher einige weitere MEMS-Bauteile gemäß der vorgeschlagenen Architektur näher beschrieben, wobei im Wesentlichen die Unterschiede zu den oben ausführlich beschriebenen MEMS-Bauteilen 100 und 500 hervorgehoben werden.

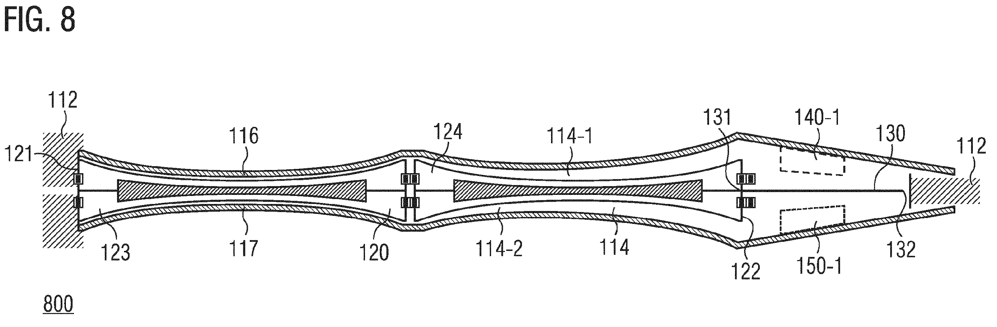

**Fig. 8** zeigt ein MEMS-Bauteil 800 mit im Vergleich zu den MEMS-Bauteilen 100 und 500 unterschiedlich ausgebildetem lateral auslenkbarem Element 120. Während das lateral auslenkbare Element 120 der MEMS-Bauteile 100 und 500 jeweils aus drei Teilelementen mit konkav gekrümmter Form gebildet ist, besteht das lateral auslenkbare Element 120 des MEMS-Bauteils 800 nur aus zwei Teilelementen mit konkav gekrümmter Form. Mit anderen Worten: Das lateral auslenkbare Element 120 ist ein zweizelliges, balanciertes Element in Fig. 8. Ferner ist im Ausführungsbeispiel die Längserstreckung des passiven Elements 130 geringer als die Längserstreckung des lateral auslenkbaren Elements 120. Ebenso weist das MEMS-Bauteil 800 keine Trennwand auf.

Die Ausgestaltung des MEMS-Bauteils 800 ist für beengte Platzverhältnisse vorteilhaft, wenn längere lateral auslenkbare Elemente mit höherer Anzahl an Zellen nicht genutzt werden können. Die zur Verfügung stehende Fläche für die Interkation (Wechselwirkung) mit dem Umgebungsfluid wird somit maximal ausgenutzt.

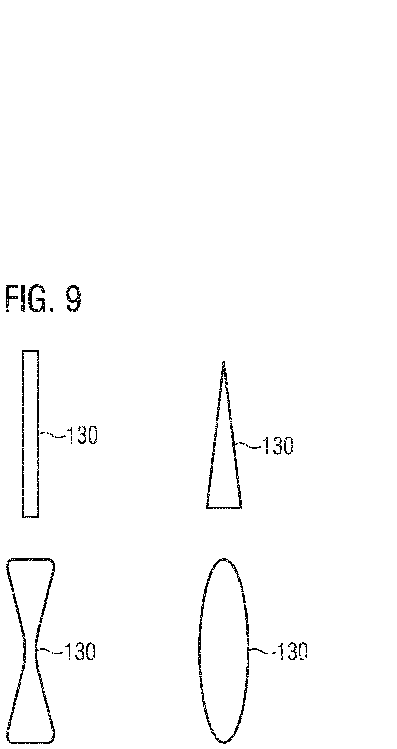

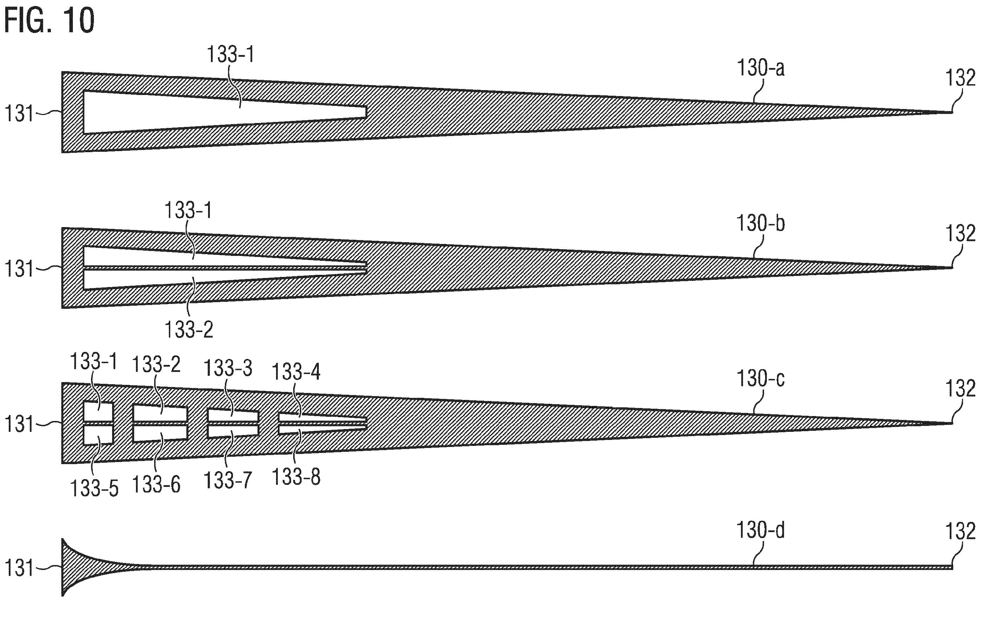

In Figs. 9 und 10 ist ferner dargestellt, wie das passiven Element 130 über entsprechende Geometrien an die jeweilige Situation angepasst werden kann. **Fig. 9** zeigt eine Schnittansicht durch das passive Element 130 (z.B. entlang einer der Schnittlinien C-C und D-D in Fig. 5), um verschiedene mögliche Querschnitte für das passive Element 130 anzudeuten. Beispielsweise kann das passive Element 130 einen balkenförmigen bzw. rechtwinkligen (siehe links oben), einen keilförmigen (siehe rechts oben), einen konkaven (siehe links unten) oder einen ovalen (siehe rechts unten) Querschnitt aufweisen.

**Fig. 10** zeigt im Weiteren eine Draufsicht auf das passive Element, um weitere Ausführungsmöglichkeiten für das passive Element anzudeuten. Insbesondere zeigt die Fig. 10 mehrere Ausführungen des passiven Elements mit verbessertem Leichtbaupotenzial. In den in Fig. 10 gezeigten Ausführungsbeispielen 130-a, 130b und 130-c ist in dem passiven Element jeweils zumindest ein Hohlraum 133-1, ..., 133-8 gebildet. Mittels des bzw. der Hohlräume kann ein verbessertes Masse-Steifigkeitsverhältnis an dem mit dem lateral auslenkbaren Element 120 verbundenen Ende 131 des passiven Elements erzielt werden. Beispielsweise kann mittels eines oder mehrerer Ätzprozesse Material des passiven Elements entfernt werden, um den oder die Hohlräume 133-1, ..., 133-8 zu bilden.

Wie im Ausführungsbeispiel 130-d, das in Fig. 10 dargestellt ist, angedeutet, kann auch über eine optimierte Geometrie bzw. Außenkontur im Bereich des mit dem lateral auslenkbaren Element 120 verbundenen Endes 131 des passiven Elements ein verbessertes Masse-Steifigkeitsverhältnis erreicht werden.

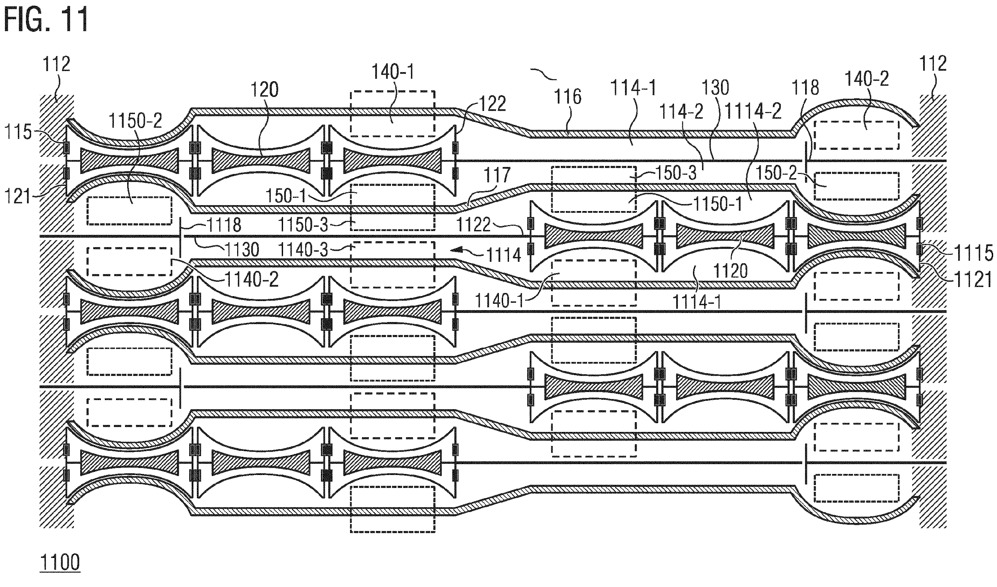

In **Fig. 11** ist ein MEMS-Bauteil 1100 gezeigt, bei dem eine Mehrzahl an Kavitäten mit dem oben beschriebenen Aufbau in der zweiten Schicht 112 gebildet sind. Obwohl in Fig. 11 fünf Kavitäten gezeigt sind, ist zu beachten, dass ein erfindungsgemäßes MEMS-Bauteil auch jede andere Mehrzahl an Kavitäten aufweisen kann. Beispielsweise kann ein erfindungsgemäßes MEMS-Bauteil auch 2, 3, 4, 6, 10, 20 oder mehr der oben beschriebenen Kavitäten aufweisen. Wie aus Fig. 11 ersichtlich ist, sind die einzelnen Kavitäten wechselseitig in der zweiten Schicht 112 angeordnet, so dass benachbarte Kavitäten um 180 ° zueinander gedreht angeordnet sind und jeweils eine gemeinsame Seitenwand aufweisen (in alternativen Ausführungsbeispielen können die Kavitäten auch gleichsinning, d.h. nicht zueinander gedreht, angeordnet sein). Mit anderen Worten: Die in den Kavitäten angeordneten Wandlersysteme sind entlang einer ersten Raumrichtung benachbart zueinander angeordnet und erstrecken sich (längs) im Wesentlichen entlang einer zweiten Raumrichtung, die senkrecht zur ersten Raumrichtung verläuft. Dabei sind die Wandlersysteme abwechselnd an gegenüberliegenden Seiten des umgebenden Substrats der zweiten Schicht 112 aufgehängt. Dies wird nachfolgend nochmals explizit anhand der ersten Kavität 114 und der zweiten Kavität 1114, die benachbart zueinander sind, ausgeführt.

Die erste Kavität 114 ist im Wesentlichen wie oben beschrieben ausgeführt und weist zusätzlich eine dritte zweite Öffnung 150-3 auf. Es wird daher auf die obigen Ausführungen verwiesen.

Entsprechend ist in der zweiten Kavität 1114 ein weiteres lateral auslenkbares Element 1120, das ein mit einer Seitenwand 1115 der zweiten Kavität 1114 verbundenes Ende 1121 sowie ein freies Ende 1122 aufweist, gebildet. Das weitere lateral auslenkbare Element 1120 ist in dem Ausführungsbeispiel der Fig. 11 identisch zu dem lateral auslenkbaren Element 120 ausgebildet. In alternativen Ausführungsbeispielen können das weitere lateral auslenkbare Element 1120 und das lateral auslenkbare Element 120 auch unterschiedlich ausgebildet sein (beispielsweise eine unterschiedliche Geometrie oder eine unterschiedliche Anzahl an Teilelementen aufweisen).

Die Seitenwand 115 der ersten Kavität 114, an welcher das lateral auslenkbare Element 120 angebracht ist, und die Seitenwand 1115 der zweiten Kavität 1114, an welcher das weitere lateral auslenkbare Element 1120 angebracht ist, liegen einander gegenüber. Die erste Kavität 114 und die zweite Kavität 1114 sind durch die gemeinsame weitere Seitenwand 117, die entlang der Längserstreckung des lateral auslenkbaren Elements 120 und entlang der Längserstreckung des weiteren lateral auslenkbaren Elements 1120 verläuft, begrenzt.

An das freie Ende 1122 des weiteren lateral auslenkbaren Elements 1120 ist ein weiteres passives Element 1130 starr angebunden, um einer Bewegung des weiteren lateral auslenkbaren Elements 1120 zu folgen. Das weitere passive Element 1130 ist in dem Ausführungsbeispiel der Fig. 11 identisch zu dem passiven Element 130 ausgebildet. In alternativen Ausführungsbeispielen können das weitere passive Element 1130 und das passive Element 130 auch unterschiedlich ausgebildet sein (beispielsweise eine unterschiedliche Geometrie oder eine unterschiedliche Länge aufweisen).

Analog zu den obigen Ausführungen für die erste Kavität 114 unterteilen das weitere lateral auslenkbare Element 1120 und das weitere passive Element 1120 zusammen mit der weitern Trennwand 1118 die zweite Kavität 1114 in eine dritte Teilkavität 1114-1 und eine vierte Teilkavität 1114-2.

Die benachbarten Kavitäten 114 und 1114 sind im MEMS-Bauteil 1100 so angeordnet, dass das jeweilige lateral auslenkbare Element 120 bzw. 1120 dem passiven Element 1130 bzw. 130 der benachbarten Kavität gegenüberliegt.

Die dritte Teilkavität 1114-1 steht über drei dritte Öffnungen 1140-1, 1140-2 und 1140-3 mit dem Umgebungsfluid des MEMS-Bauteils 1110 in Kontakt. Entsprechend steht die vierte Teilkavität 1114-2 über drei vierte Öffnungen 1150-1, 1150-2 und 1150-3 mit dem Umgebungsfluid des MEMS-Bauteils 1100 in Kontakt. Analog zu den obigen Ausführungen für die ersten und dritten Öffnungen ist zu beachten, dass die in Fig. 11 dargestellte Anzahl an Öffnungen beispielhaft ist und rein der Illustration dient. Gemäß Ausführungsbeispielen kann jede beliebige Anzahl (n ≥ 1) an Öffnungen verwendet werden, um die dritte Teilkavität 1114-1 und die vierte Teilkavität 1114-2 mit dem Umgebungsfluid in Kontakt zu bringen.

Die dritten Öffnungen 1140-1, 1140-2 und 1140-3 sind wiederum in einer anderen Schicht der ersten Schicht 111 und der dritten Schicht 113 als die vierten Öffnungen 1150-1, 1150-2 und 1150-3 gebildet, um einen akustischen Kurzschluss zwischen der dritten Teilkavität 1114-1 und der vierten Teilkavität 1114-2 zu vermeiden.

Die zweiten Öffnungen 150-1, 150-2 und 150-3 sind in dem Ausführungsbeispiel der Fig. 11 in der der gleichen Schicht der ersten Schicht und der dritten Schicht gebildet wie die vierten Öffnungen 1150-1, 1150-2 und 1150-3. Wie aus Fig. 11 ersichtlich ist, bilden die zweite Öffnung 150-1 und die vierte Öffnung 1150-3 sowie die zweite Öffnung 150-3 und die vierte Öffnung 1150-1 jeweils eine zusammenhängende Öffnung. Die zweite Teilkavität 114-2 ist somit mit der benachbarten vierten Teilkavität 1114-2 kurzgeschlossen. Dies ist möglich, da die laterale Bewegung des weiteren passiven Elements 1130 und des weiteren lateral auslenkbaren Elements 1120 gegenläufig zu der Bewegung des passiven Elements 130 und des lateral auslenkbaren Elements 120 ist, so dass die Volumina der zweiten Teilkavität 114-2 und der vierten Teilkavität 1114-2 sich im Wesentlichen gleichartig ändern. Die benachbarten Kavitäten 114 und 1114 sind somit in Bereichen, in denen das jeweilige lateral auslenkbare Element 120 bzw. 1120 dem passiven Element 1130 bzw. 130 der benachbarten Kavität gegenüberliegt, miteinander verbunden.

Aus Fig. 11 ist ferner ersichtlich, dass die zumindest teilweise Anpassung der jeweiligen Verläufe der weiteren Seitenwände 116 und 117 an die Außenkontur des lateral auslenkbaren Elements 120 eine Vergrößerung des Volumens der benachbarten Kavitäten im Bereich des freien Endes ihrer jeweiligen passiven Elemente ermöglicht. Beispielsweise ermöglicht die Anpassung des Verlaufs der Seitenwand 117 an die gekrümmte Kontur der ersten Zelle des lateral auslenkbaren Elements 120 eine Vergrößerung des Volumens der zweiten Kavität 1114 im Bereich des freien Endes 1132 des weiteren passiven Elements 1130 bzw. im Bereich der Trennwand 1118 der zweiten Kavität 1114. Das lateral auslenkbare Element 120 erfährt in diesem Bereich seine geringste Verformung, so dass die ovale Ausgestaltung der Seitenwand 117 in diesem Bereich eine Maximierung des Volumens der zweiten Kavität 1114 ermöglicht. Entsprechend kann in der zweiten Kavität 1114 mit einem größeren Volumen des Umgebungsfluids interagiert werden.

Die für die Kavitäten 114 und 1114 gemachten Ausführung gelten in analoger Weise auch für die weiteren Kavitäten des MEMS-Bauteil 1100.

Während die vorangehenden Abschnitte sich auf die Details von MEMS-Bauteilen gemäß der vorgeschlagenen Architektur konzentriert haben, soll im Folgenden näher auf die Anwendung der MEMS-Bauteile eingegangen werden.

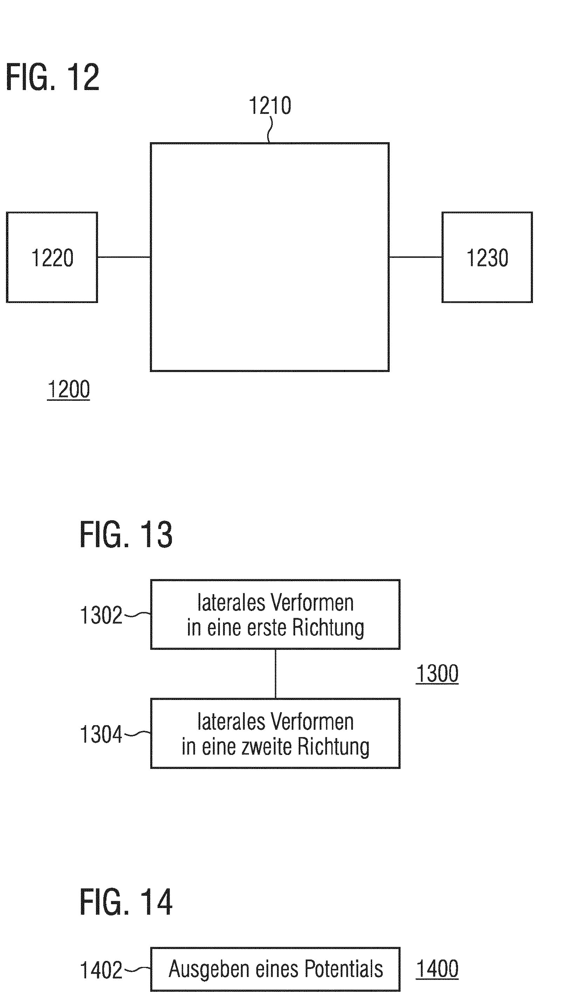

Dazu ist in **Fig. 12** eine Baugruppe 1200 dargestellt. Die Baugruppe 1200 umfasst zumindest ein MEMS-Bauteil 1210 gemäß der vorgeschlagenen Architektur bzw. einem der hierein beschriebenen Ausführungsbeispiele. Umfasst die Baugruppe 1200 mehrere MEMS-Bauteile 1210, so können die Mehrzahl an MEMS-Bauteilen 1210 im Wesentlichen beliebig zueinander ausgerichtet sein. Beispielsweise können die Mehrzahl an MEMS-Bauteilen 1210 auf einem gemeinsamen Halbleiterchip oder einem Halbleiter-Die ausgebildet sein.

Abhängig von der Art der Baugruppe 1200 kann die Baugruppe eine Steuerschaltung 1220 und/oder eine Messschaltung 1230 aufweisen.

Die Steuerschaltung 1320 ist eingerichtet, zumindest ein erstes Potential (z.B. ein erstes Spannungssignal, ein erstes magnetisches Potential oder ein erstes thermisches Potential) für das lateral auslenkbare Element des zumindest einen MEMS-Bauteils 1210 bereitzustellen, um das lateral auslenkbare Element als Aktor zur Beeinflussung des Umgebungsfluid zu betreiben.

Die Messschaltung 1330 ist eingerichtet, zumindest ein zweites Potential (z.B. ein zweites Spannungssignal, ein zweites magnetisches Potential oder ein zweites thermisches Potential) des lateral auslenkbaren Elements des zumindest einen MEMS-Bauteils 1210 zu messen, um das lateral auslenkbare Element als Sensor für das Umgebungsfluid zu betreiben.

Soll das zumindest eine MEMS-Bauteil 1210 als Aktor betrieben werden, weist die Baugruppe 1200 die Steuerschaltung 1220 auf. Beispielsweise kann die Baugruppe 1200 ein Kopfhörer, ein Lautsprecher, ein Lautsprecher eines Kopfhörers, ein Lautsprecher eines (ultra-) mobilen Endgeräts oder dergleichen sein, so dass über das zumindest eine MEMS-Bauteil 1210 eine Beeinflussung des das zumindest eine MEMS-Bauteil 1210 umgebenden Umgebungsfluides zur Ausgabe eines Schallsignals erfolgt. Gemäß weiteren Ausführungsbeispielen kann die Baugruppe 1200 auch eine Fluidpumpe sein, so dass über das zumindest eine MEMS-Bauteil 1210 eine Beeinflussung des das zumindest eine MEMS-Bauteil 1210 umgebenden Umgebungsfluides zum Fluidtransport erfolgt.

Soll das zumindest eine MEMS-Bauteil 1210 als Sensor betrieben werden, weist die Baugruppe 1200 die Messschaltung 1230 auf. Beispielsweise kann die Baugruppe 1200 ein Mikrofon sein, dass über das zumindest eine MEMS-Bauteil 1210 eine Sensierung des das zumindest eine MEMS-Bauteil 1210 umgebenden Umgebungsfluides ermöglicht.

Umfasst die Baugruppe 1200 mehrere MEMS-Bauteile 1210, so kann gemäß Ausführungsbeispielen ein erster Teil der Mehrzahl an MEMS-Bauteilen 1210 als Aktoren und ein zweiter Teil der Mehrzahl an MEMS-Bauteilen 1210 als Sensoren betrieben werden. Beispielsweise kann die Baugruppe 1200 in dieser Ausführungsform ein Kopfhörer mit aktiver Geräuschunterdrückung (engl. noise cancelling) sein.

Um die oben beschriebenen Aspekte zum Betreiben der hierin beschriebenen MEMS-Bauteile nochmals zusammenzufassen, sind in den Fig. 13 und 14 noch Ablaufdiagramme zweier Verfahren zum Betreiben der hierin beschriebenen MEMS-Bauteile gezeigt.

**Fig. 13** zeigt ein Ablaufdiagramm eines ersten Verfahrens 1300 zum Betreiben eines hierin beschriebenen MEMS-Bauteils. Das Verfahren 1300 umfasst ein laterales Verformen 1302 des lateral auslenkbaren Elements in eine erste Richtung durch Anlegen eines Potentials (z.B. eines Spannungssignals), um während eines ersten Zeitintervalls zur Beeinflussung des Umgebungsfluides ein Volumen der ersten Teilkavität zu vergrößern und ein Volumen der zweiten Teilkavität zu verringern. Weiterhin umfasst das Verfahren 1300 ein laterales Verformen 1304 des lateral auslenkbaren Elements in eine entgegengesetzte zweite Richtung durch Anlegen des Potentials, um während eines zweiten Zeitintervalls zur Beeinflussung des Umgebungsfluides das Volumen der zweiten Teilkavität zu vergrößern und das Volumen der ersten Teilkavität zu verringern.

Das Verfahren 1300 kann eine kontrollierte Beeinflussung des Umgebungsfluides basierend auf dem angelegten Potential ermöglichen. Aufgrund der Ausgestaltung des lateral auslenkbaren Elements und des passiven Elements in der Kavität kann die zur Verfügung stehende Fläche des MEMS-Bauteils zu einem hohen Grad für die Beeinflussung des Umgebungsfluid genutzt werden. Das Verfahren 1300 kann für den Betrieb des MEMS-Bauteils als Aktor genutzt werden.

Weitere Details und Aspekte des Verfahrens 1300 sind oben in Zusammenhang mit weiteren Ausführungsbeispielen (z.B. Figs. 1 bis 10) beschrieben. Das Verfahren 1300 kann eines oder mehrere optionale Merkmale gemäß den weiteren Ausführungsbeispielen umfassen. **Fig. 14** zeigt ein Ablaufdiagramm eines zweiten Verfahrens 1400 zum Betreiben eines hierin beschriebenen MEMS-Bauteils, bei dem sich das lateral auslenkbare Element und das passive Element gegenüber Seitenwänden der ersten Kavität lateral bewegen können, um abhängig von dem Umgebungsfluid Volumina der ersten Teilkavität und der zweiten Teilkavität einzustellen. Das Verfahren 1400 umfasst ein Ausgeben 1402 eines Potentials (z.B. eines Spannungssignals) durch das lateral auslenkbare Element bei lateraler Verformung aufgrund einer äußeren Krafteinwirkung durch die Verschiebung des lateral auslenkbaren Elements und des passiven Elements gegenüber den Seitenwänden der ersten Kavität. Aufgrund der Ausgestaltung des lateral auslenkbaren Elements und des passiven Elements in der Kavität kann die zur Verfügung stehende Fläche des MEMS-Bauteils zu einem hohen Grad für die Sensierung des Umgebungsfluid genutzt werden. Das Verfahren 1400 kann für den Betrieb des MEMS-Bauteils als Sensor genutzt werden.

Weitere Details und Aspekte des Verfahrens 1400 sind oben in Zusammenhang mit weiteren Ausführungsbeispielen (z.B. Figs. 1 bis 10) beschrieben. Das Verfahren 1400 kann eines oder mehrere optionale Merkmale gemäß den weiteren Ausführungsbeispielen umfassen.

Ausführungsbeispiele der vorliegenden Offenbarung, soweit sie unter den Wortlaut der Patentansprüche fallen, betreffen somit unter anderem:
Einen MEMS-Wandler mit vergrößerter fluidischer Wirkfläche bestehend aus einem Aktor (aktives Element) und einem passiven Element.

Ausführungsbeispiele, in denen der Aktor einseitig mit dem Substrat verbunden ist. Ausführungsbeispiele, in denen das passive Element an dessen frei schwingendem Ende starr verbunden ist und der Bewegung des Aktors folgt.

Ausführungsbeispiele, in denen das passive Element eine zum Aktor zumindest vergleichbare oder höhere Steifigkeit aufweist.

Ausführungsbeispiele, in denen das passive Element stabförmig ausgebildet ist.

Ausführungsbeispiele, in denen das passive Element in der Draufsicht eine veränderliche Dicke hat, die an der Verbindungsstelle zum Aktor die größten geometrischen Abmessungen hat und an dem frei schwingenden Ende die geringsten geometrischen Abmessungen hat.

Ausführungsbeispiele, in denen eine laterale Verformung der einseitig eingespannten Biegewandler basierend auf einem elektrischen Potential erfolgt.

Ausführungsbeispiele, in denen eine Länge des passiven Elementes 20 - 160 % der Länge des Aktors, bevorzugt 60 - 100 % und besonders bevorzugt 80 % entspricht. Ausführungsbeispiele, in denen benachbarte Wandler in einem Wandlersystem so angeordnet sind, dass sie gegenüberliegend eingespannt sind.

Ausführungsbeispiele, in denen Aktor und passives Element in einer Kavität eingefasst sind. Die Kavität ist dabei durch die in der Substratebene angeordnete Berandung, sowie Deckel- und Handlingwafer gebildet. Benachbarte Wandler teilen sich eine gemeinsame Berandung. Wandler, jeweils bestehend aus Aktor und passiven Element, teilen die Kavität in zwei Teilkavitäten.

Ausführungsbeispiele, in denen Öffnungen im Deckel- und Handlingwafer die Teilkavitäten mit der Umgebung verbinden. Die Öffnungen können über der gemeinsamen Berandung angeordnet sein, sodass benachbarte Teilkavitäten miteinander verbunden sind.

Durch die Beschreibung und Zeichnungen werden nur die Grundsätze der Offenbarung dargestellt. Weiterhin sollen alle hier aufgeführten Beispiele grundsätzlich ausdrücklich nur illustrativen Zwecken dienen, um den Leser beim Verständnis der Grundsätze der Offenbarung und der durch die Erfinder beigetragenen Konzepte zur Weiterentwicklung der Technik zu unterstützen. Alle hiesigen Aussagen über Grundsätze, Aspekte und Beispiele der Offenbarung sowie konkrete Beispiele derselben umfassen deren Entsprechungen.

## Patentansprüche

1. MEMS-Bauteil, umfassend:
einen Schichtstapel (110) mit zumindest einer zwischen einer ersten Schicht (111) und einer dritten Schicht (113) gebildeten zweiten Schicht (112), wobei in der zweiten Schicht (112) zumindest eine erste Kavität (114) gebildet ist;
ein lateral auslenkbares Element (120), das ein mit einer Seitenwand (115) der ersten Kavität (114) verbundenes Ende (121) sowie ein freies Ende (122) aufweist, wobei das lateral auslenkbare Element (120) in der Ebene der zweiten Schicht (112) auslenkbar ist; und
ein passives Element (130), das starr an das freie Ende (122) des lateral auslenkbaren Elements (120) angebunden ist, um einer Bewegung des lateral auslenkbaren Elements (120) zu folgen;
wobei das lateral auslenkbare Element (120) und das passive Element (130) die erste Kavität (114) in eine erste Teilkavität (114-1) und eine zweite Teilkavität (114-2) unterteilen,
wobei die erste Teilkavität (114-1) über zumindest eine erste Öffnung (140-1, 140-2) mit einem Umgebungsfluid des MEMS-Bauteils in Kontakt steht,
wobei die zweite Teilkavität (114-2) über zumindest eine zweite Öffnung (150-1, 150-2) mit dem Umgebungsfluid des MEMS-Bauteils in Kontakt steht,
wobei die zumindest eine zweite Öffnung (150-1, 150-2) in der ersten Schicht (111) oder der dritten Schicht (113) gebildet ist, und
wobei die zumindest eine erste Öffnung (140-1, 140-2) in einer anderen Schicht der ersten Schicht (111) und der dritten Schicht (113) als die zumindest eine zweite Öffnung (150-1, 150-2) gebildet ist.

2. MEMS-Bauteil nach Anspruch 1, wobei eine Steifigkeit des passiven Elements (130) größer oder gleich einer Steifigkeit des lateral auslenkbaren Elements (120) ist.

3. MEMS-Bauteil nach Anspruch 1 oder Anspruch 2, wobei eine Erstreckung des passiven Elements (130) entlang einer Dickenrichtung der zweiten Schicht (112) gleich zu einer Erstreckung des lateral auslenkbaren Elements (120) entlang der Dickenrichtung der zweiten Schicht (112) ist.

4. MEMS-Bauteil nach Anspruch 1 oder Anspruch 2, wobei eine Erstreckung des passiven Elements (130) entlang einer Dickenrichtung der zweiten Schicht (112) zumindest teilweise geringer als eine Erstreckung des lateral auslenkbaren Elements (120) entlang der Dickenrichtung der zweiten Schicht (112) ist.

5. MEMS-Bauteil nach einem der Ansprüche 1 bis 4, wobei ein Querschnitt des passiven Elements (130) entlang seiner Längserstreckung kleiner als ein Querschnitt des lateral auslenkbaren Elements (120) entlang seiner Längserstreckung ist.

6. MEMS-Bauteil nach einem der Ansprüche 1 bis 5, wobei ein Querschnitt des passiven Elements (130) von einem mit dem lateral auslenkbaren Element verbundenen Ende (131) des passiven Elements (130) zu einem freien Ende (132) des passiven Elements (130) hin abnimmt.

7. MEMS-Bauteil nach einem der Ansprüche 1 bis 6, wobei in dem passiven Element (130) zumindest ein Hohlraum (133-1, ..., 133-8) gebildet ist.

8. MEMS-Bauteil nach einem der Ansprüche 1 bis 7, wobei ein Verhältnis einer Längserstreckung des passiven Elements (130) zu seiner Lateralerstreckung größer als 10:1 ist.

9. MEMS-Bauteil nach einem der Ansprüche 1 bis 8, wobei eine Längserstreckung des passiven Elements (130) zwischen 20 % und 160 % einer Längserstreckung des lateral auslenkbaren Elements (120) beträgt.

10. MEMS-Bauteil nach einem der Ansprüche 1 bis 9, wobei die erste Kavität (114) durch zwei weitere Seitenwände (116, 117) begrenzt ist, wobei sich das lateral auslenkbare Element (120) entlang seiner Längserstreckung zwischen den zwei weiteren Seitenwänden (116, 117) erstreckt, und wobei jeweilige Verläufe der weiteren Seitenwände (116, 117) zumindest zum Teil an eine Außenkontur des lateral auslenkbaren Elements (120) angepasst sind.

11. MEMS-Bauteil nach einem der Ansprüche 1 bis 10, wobei in der ersten Kavität (114) ferner eine Trennwand (118) gebildet ist, welche zusammen mit dem lateral auslenkbaren Element und dem passiven Element (130) die erste Kavität (114) in die erste Teilkavität (114-1) und die zweite Teilkavität (114-2) unterteilt, wobei ein Spalt zwischen der Trennwand (118) und einem freien Ende (132) des passiven Elements (130) gebildet ist, um eine Bewegung des passiven Elements (130) relativ zu der Trennwand (118) zu ermöglichen.

12. MEMS-Bauteil nach einem der Ansprüche 1 bis 11, wobei die erste Teilkavität (114-1) über zwei erste Öffnungen (140-1, 140-2) mit dem Umgebungsfluid des MEMS-Bauteils in Kontakt steht, wobei eine der zwei ersten Öffnungen (140-1, 140-2) in einem Bereich der ersten Teilkavität (114-1) angeordnet ist, in dem sich das lateral auslenkbare Element (120) erstreckt, und wobei die andere der zwei ersten Öffnungen (140-1, 140-2) in einem davon verschiedenen Bereich der ersten Teilkavität (114-1) angeordnet ist.

13. MEMS-Bauteil nach einem der Ansprüche 1 bis 12, wobei das lateral auslenkbare Element (120) ausgebildet ist, sich bei Anlegen eines ersten Potentials lateral zu verformen, so dass sich das lateral auslenkbare Element (120) und das passive Element (130) gegenüber Seitenwänden (116, 117) der ersten Kavität (114) bewegen, um zur Beeinflussung des Umgebungsfluid ein Volumen der ersten Teilkavität (114-1) abwechselnd zu verringern und zu vergrößern und umgekehrt ein Volumen der zweiten Teilkavität (114-2) abwechselnd zu vergrößern bzw. zu verringern.

14. MEMS-Bauteil nach einem der Ansprüche 1 bis 13, wobei das lateral auslenkbare Element (120) eine erste Elektrodenschicht und eine zweite Elektrodenschicht, zwischen denen eine nicht-leitende Schicht ausgebildet ist, umfasst, wobei das lateral auslenkbare Element (120) ausgebildet ist:
sich bei Anlegen eines ersten Spannungssignals an die erste Elektrodenschicht und die zweite Elektrodenschicht lateral zu verformen; und/oder
bei lateraler Verformung aufgrund einer äußeren Krafteinwirkung ein zweites Spannungssignal an der ersten Elektrodenschicht und der zweiten Elektrodenschicht zu erzeugen.

15. MEMS-Bauteil nach einem der Ansprüche 1 bis 14, ferner umfassend:
eine zweite Kavität (1114), die in der zweiten Schicht (112) gebildet ist;
ein weiteres lateral auslenkbares Element (1120), das ein mit einer Seitenwand (1115) der zweiten Kavität (1114) verbundenes Ende (1121) sowie ein freies Ende (1122) aufweist;
ein weiteres passives Element (1130), das starr an das freie Ende (1122) des weiteren lateral auslenkbaren Elements (1120) angebunden ist, um einer Bewegung des weiteren lateral auslenkbaren Elements (1120) zu folgen;
wobei das weitere lateral auslenkbare Element (1120) und das weitere passive Element (1130) die zweite Kavität in eine dritte Teilkavität (1114-1) und eine vierte Teilkavität (1114-2) unterteilen,
wobei die dritte Teilkavität (1114-1) über zumindest eine dritte Öffnung (1140-1, 1140-2) mit dem Umgebungsfluid des MEMS-Bauteils in Kontakt steht,
wobei die vierte Teilkavität (1114-2) über zumindest eine vierte Öffnung (1150-1, 1150-2) mit dem Umgebungsfluid des MEMS-Bauteils in Kontakt steht, und
wobei die zumindest eine dritte Öffnung (1140-1, 1140-2) in einer anderen Schicht der ersten Schicht (111) und der dritten Schicht (113) als die zumindest eine vierte Öffnung (1150-1, 1150-2) gebildet ist.

## Claims

1. A MEMS device, comprising:
a layer stack (110) having at least one second layer (112) formed between a first layer (111) and a third layer (113), wherein at least a first cavity (114) is formed in the second layer (112);
a laterally deflectable element (120) having an end (121) connected to a sidewall (115) of the first cavity (114) and a free end (122), wherein the laterally deflectable element (120) is deflectable in the plane of the second layer (112); and
a passive element (130) rigidly connected to the free end (122) of the laterally deflectable element (120) to follow a movement of the laterally deflectable element (120);
wherein the laterally deflectable element (120) and the passive element (130) divide the first cavity (114) into a first sub-cavity (114-1) and a second sub-cavity (114-2),
wherein the first sub-cavity (114-1) is in contact with an ambient fluid of the MEMS device via at least one first opening (140-1, 140-2),
wherein the second sub-cavity (114-2) is in contact with the ambient fluid of the MEMS device via at least one second opening (150-1, 150-2),
wherein the at least one second opening (150-1, 150-2) is formed in the first layer (111) or the third layer (113), and
wherein the at least one first opening (140-1, 140-2) is formed in a different layer of the first layer (111) and the third layer (113) than the at least one second opening (150-1, 150-2).

2. The MEMS device of claim 1, wherein a stiffness of the passive element (130) is greater than or equal to a stiffness of the laterally deflectable element (120).

3. The MEMS device of claim 1 or claim 2, wherein an extension of the passive element (130) along a thickness direction of the second layer (112) is equal to an extension of the laterally deflectable element (120) along the thickness direction of the second layer (112).

4. The MEMS device of claim 1 or claim 2, wherein an extension of the passive element (130) along a thickness direction of the second layer (112) is at least partially smaller than an extension of the laterally deflectable element (120) along the thickness direction of the second layer (112).

5. The MEMS device of any one of claims 1 to 4, wherein a cross-section of the passive element (130) along its longitudinal extension is smaller than a cross-section of the laterally deflectable element (120) along its longitudinal extension.

6. The MEMS device of any one of claims 1 to 5, wherein a cross-section of the passive element (130) decreases from an end (131) of the passive element (130) connected to the laterally deflectable element towards a free end (132) of the passive element (130).

7. The MEMS device of any one of claims 1 to 6, wherein at least one cavity (133-1, ..., 133-8) is formed in the passive element (130).

8. The MEMS device of any one of claims 1 to 7, wherein a ratio of a longitudinal extension of the passive element (130) to its lateral extension is greater than 10:1.

9. The MEMS device of any one of claims 1 to 8, wherein a longitudinal extension of the passive element (130) is between 20% and 160% of a longitudinal extension of the laterally deflectable element (120).

10. The MEMS device of any one of claims 1 to 9, wherein the first cavity (114) is delimited by two further sidewalls (116, 117), wherein the laterally deflectable element (120) extends along its longitudinal extension between the two further sidewalls (116, 117), and wherein respective profiles of the further sidewalls (116, 117) are at least partially adapted to an outer contour of the laterally deflectable element (120).

11. The MEMS device of any one of claims 1 to 10, wherein a partition wall (118) is further formed in the first cavity (114), which together with the laterally deflectable element and the passive element (130) divides the first cavity (114) into the first sub-cavity (114-1) and the second sub-cavity (114-2), wherein a gap is formed between the partition wall (118) and a free end (132) of the passive element (130) to enable a movement of the passive element (130) relative to the partition wall (118).

12. The MEMS device of any one of claims 1 to 11, wherein the first sub-cavity (114-1) is in contact with the ambient fluid of the MEMS device via two first openings (140-1, 140-2), wherein one of the two first openings (140-1, 140-2) is arranged in a region of the first sub-cavity (114-1) in which the laterally deflectable element (120) extends, and wherein the other of the two first openings (140-1, 140-2) is arranged in a region of the first sub-cavity (114-1) which is different therefrom.

13. The MEMS device of any one of claims 1 to 12, wherein the laterally deflectable element (120) is configured to deform laterally upon application of a first potential, such that the laterally deflectable element (120) and the passive element (130) move with respect to sidewalls (116, 117) of the first cavity (114) in order to alternately reduce and increase a volume of the first sub-cavity (114-1) for influencing the ambient fluid, and conversely alternately increase and/or reduce a volume of the second sub-cavity (114-2).

14. The MEMS device of any one of claims 1 to 13, wherein the laterally deflectable element (120) comprises a first electrode layer and a second electrode layer between which a non-conductive layer is configured, wherein the laterally deflectable element (120) is configured to:
deform laterally when a first voltage signal is applied to the first electrode layer and the second electrode layer; and/or
generate a second voltage signal at the first electrode layer and the second electrode layer in case of lateral deformation due to an application of external force.

15. The MEMS device of any one of claims 1 to 14, further comprising:
a second cavity (1114) formed in the second layer (112);
a further laterally deflectable element (1120) having an end (1121) connected to a sidewall (1115) of the second cavity (1114) and a free end (1122);
a further passive element (1130) rigidly connected to the free end (1122) of the further laterally deflectable element (1120) to follow a movement of the further laterally deflectable element (1120);
wherein the further laterally deflectable element (1120) and the further passive element (1130) divide the second cavity into a third sub-cavity (1114-1) and a fourth sub-cavity (1114-2),
wherein the third sub-cavity (1114-1) is in contact with the ambient fluid of the MEMS device via at least one third opening (1140-1, 1140-2),
wherein the fourth sub-cavity (1114-2) is in contact with the ambient fluid of the MEMS device via at least one fourth opening (1150-1, 1150-2), and
wherein the at least one third opening (1140-1, 1140-2) is formed in a different layer of the first layer (111) and the third layer (113) than the at least one fourth opening (1150-1, 1150-2).

## Revendications

1. Composant MEMS, comprenant :
un empilement de couches (110) ayant au moins une deuxième couche (112) formée entre une première couche (111) et une troisième couche (113), dans lequel au moins une première cavité (114) est formée dans la deuxième couche (112) ;
un élément (120) pouvant être dévié latéralement ayant une extrémité (121) connectée à une paroi latérale (115) de la première cavité (114) et une extrémité libre (122), dans lequel l'élément (120) pouvant être dévié latéralement peut être dévié dans le plan de la deuxième couche (112) ; et
un élément passif (130) attaché de manière rigide à l'extrémité libre (122) de l'élément (120) pouvant être dévié latéralement pour suivre un mouvement de l'élément (120) pouvant être dévié latéralement ;
dans lequel l'élément (120) pouvant être dévié latéralement et l'élément passif (130) divisent la première cavité (114) en une première sous-cavité (114-1) et une deuxième sous-cavité (114-2),
dans lequel la première sous-cavité (114-1) est en contact avec un fluide ambiant du composant MEMS par l'intermédiaire d'au moins une première ouverture (140-1, 140-2),
dans lequel la deuxième sous-cavité (114-2) est en contact avec le fluide ambiant du composant MEMS par l'intermédiaire d'au moins une deuxième ouverture (150-1, 150-2),
dans lequel l'au moins une deuxième ouverture (150-1, 150-2) est formée dans la première couche (111) ou la troisième couche (113), et
dans lequel l'au moins une première ouverture (140-1, 140-2) est formée dans une autre couche de la première couche (111) et de la troisième couche (113) que l'au moins une deuxième ouverture (150-1, 150-2).

2. Composant MEMS selon la revendication 1, dans lequel une rigidité de l'élément passif (130) est supérieure ou égale à une rigidité de l'élément (120) pouvant être dévié latéralement.

3. Composant MEMS selon la revendication 1 ou la revendication 2, dans lequel une extension de l'élément passif (130) le long d'une direction d'épaisseur de la deuxième couche (112) est égale à une extension de l'élément (120) pouvant être dévié latéralement le long de la direction d'épaisseur de la deuxième couche (112).

4. Composant MEMS selon la revendication 1 ou la revendication 2, dans lequel une extension de l'élément passif (130) le long d'une direction d'épaisseur de la deuxième couche (112) est au moins partiellement inférieure à une extension de l'élément (120) pouvant être dévié latéralement le long de la direction d'épaisseur de la deuxième couche (112).

5. Composant MEMS selon l'une des revendications 1 à 4, dans lequel une section transversale de l'élément passif (130) le long de son extension longitudinale est inférieure à une section transversale de l'élément (120) pouvant être dévié latéralement le long de son extension longitudinale.

6. Composant MEMS selon l'une des revendications 1 à 5, dans lequel une section transversale de l'élément passif (130) diminue d'une extrémité (131) de l'élément passif (130) connectée à l'élément pouvant être dévié latéralement vers une extrémité libre (132) de l'élément passif (130).

7. Composant MEMS selon l'une des revendications 1 à 6, dans lequel au moins une cavité (133-1, ..., 133-8) est formée dans l'élément passif (130).

8. Composant MEMS selon l'une des revendications 1 à 7, dans lequel un rapport d'une extension longitudinale de l'élément passif (130) à son extension latérale est supérieur à 10:1.

9. Composant MEMS selon l'une des revendications 1 à 8, dans lequel une extension longitudinale de l'élément passif (130) est comprise entre 20 % et 160 % d'une extension longitudinale de l'élément (120) pouvant être dévié latéralement.

10. Composant MEMS selon l'une des revendications 1 à 9, dans lequel la première cavité (114) est délimitée par deux autres parois latérales (116, 117), l'élément (120) pouvant être dévié latéralement s'étendant le long de son extension longitudinale entre les deux autres parois latérales (116, 117), et des tracés respectifs des autres parois latérales (116, 117) étant adaptés au moins en partie à un contour extérieur de l'élément (120) pouvant être dévié latéralement.

11. Composant MEMS selon l'une des revendications 1 à 10, dans lequel une paroi de séparation (118) est en outre formée dans la première cavité (114), laquelle, conjointement avec l'élément pouvant être dévié latéralement et l'élément passif (130), divise la première cavité (114) en la première sous-cavité (114-1) et la deuxième sous-cavité (114-2), une fente étant formée entre la paroi de séparation (118) et une extrémité libre (132) de l'élément passif (130) pour permettre un mouvement de l'élément passif (130) par rapport à la paroi de séparation (118).

12. Composant MEMS selon l'une des revendications 1 à 11, dans lequel la première sous-cavité (114-1) est en contact avec le fluide ambiant du composant MEMS par l'intermédiaire de deux premières ouvertures (140-1, 140-2), l'une des deux premières ouvertures (140-1, 140-2) étant disposée dans une région de la première sous-cavité (114-1) dans laquelle s'étend l'élément (120) pouvant être dévié latéralement, et l'autre des deux premières ouvertures (140-1, 140-2) étant disposée dans une région de la première sous-cavité (114-1) différente de celle-ci.

13. Composant MEMS selon l'une des revendications 1 à 12, dans lequel l'élément (120) pouvant être dévié latéralement est configuré pour se déformer latéralement lors de l'application d'un premier potentiel, de sorte que l'élément (120) pouvant être dévié latéralement et l'élément passif (130) se déplacent par rapport à des parois latérales (116, 117) de la première cavité (114) pour diminuer et augmenter en alternance un volume de la première sous-cavité (114-1) pour influencer le fluide ambiant et inversement pour augmenter et/ou diminuer en alternance un volume de la deuxième sous-cavité (114-2).

14. Composant MEMS selon l'une des revendications 1 à 13, dans lequel l'élément (120) pouvant être dévié latéralement comprend une première couche d'électrodes et une deuxième couche d'électrodes entre lesquelles une couche non-conductrice est configurée, ledit élément (120) pouvant être dévié latéralement étant configuré pour :
se déformer latéralement lorsqu'un premier signal de tension est appliqué à la première couche d'électrodes et à la deuxième couche d'électrodes ; et/ou
générer un deuxième signal de tension à la première couche d'électrodes et à la deuxième couche d'électrodes en cas de déformation latérale en raison de l'application d'une force extérieure.

15. Composant MEMS selon l'une des revendications 1 à 14, comprenant en outre :
une deuxième cavité (1114) formée dans la deuxième couche (112) ;
un autre élément (1120) pouvant être dévié latéralement ayant une extrémité (1121) connectée à une paroi latérale (1115) de la deuxième cavité (1114) et une extrémité libre (1122) ;
un autre élément passif (1130) attaché de manière rigide à l'extrémité libre (1122) de l'autre élément (1120) pouvant être dévié latéralement pour suivre un mouvement de l'autre élément (1120) pouvant être dévié latéralement ;
dans lequel l'autre élément (1120) pouvant être dévié latéralement et l'autre élément passif (1130) divisent la deuxième cavité en une troisième sous-cavité (1114-1) et une quatrième sous-cavité (1114-2),
dans lequel la troisième sous-cavité (1114-1) est en contact avec le fluide ambiant du composant MEMS par l'intermédiaire d'au moins une troisième ouverture (1140-1, 1140-2),
dans lequel la quatrième sous-cavité (1114-2) est en contact avec le fluide ambiant du composant MEMS par l'intermédiaire d'au moins une quatrième ouverture (1150-1, 1150-2), et
dans lequel l'au moins une troisième ouverture (1140-1, 1140-2) est formée dans une autre couche de la première couche (111) et de la troisième couche (113) que l'au moins une quatrième ouverture (1150-1, 1150-2).
